# EUROPEAN PATENT APPLICATION

(11) **EP 3 957 775 A1**
(43) Date of publication of application: **23.02.2022**
(21) Application number: 21190418.0
(22) Date of filing: 09.08.2021
(51) Int. Cl.: C30B 23/02, C30B 29/24

(54) **HETEROSTRUCTURE MEMBRANES AND PROCESS FOR FABRICATING HETEROSTRUCTURE MEMBRANES**

(30) Priority: 21.08.2020 IT 202000020317
(71) Applicant: Consiglio Nazionale Delle Ricerche, 00185 Roma (IT)
(72) Inventor: MILETTO GRANOZIO, Fabio, I-80122 NAPOLI (IT); SAMBRI, Alessia, I-80136 NAPOLI (IT)
(74) Representative: Porta & Consulenti Associati S.p.A.

(57) **Abstract**

A process of fabricating free-standing LaAlO₃/SrTiO₃ (LAO/STO) heterostructure membranes by pulsed laser deposition, the process comprising: placing a STO monocrystalline substrate (15) having a substrate surface (15a) in a processing chamber (19) under vacuum and containing oxygen gas at an oxygen partial pressure, and epitaxially growing a LAO film on the substrate surface by pulsed laser ablation of a LAO target (13) by a pulsed laser beam (11), while the STO substrate (15) is at a substrate temperature of 660°C to 800°C, the target (13) being placed in the processing chamber (19) to face the substrate surface (15a), wherein during growth of the LAO film the pulsed laser beam (11) has a laser pulse fluence on the LAO target (13) of 1.5 J/cm² to 3.0 J/cm² and the oxygen partial pressure inside the processing chamber (19) is of 0.5x10⁻³ to 5.0x10⁻² mbar. The invention relates also to a free-standing LAO/STO heterostructure membrane.

## Description

The present invention concerns a process of fabricating perovskite heterostructures by pulsed laser deposition and in particular free-standing membrane-like perovskite heterostructures. The present invention concerns also free-standing perovskite heterostructure membranes.

The discovery of interface conductivity between two wide-gap perovskite oxide insulators LaAlO₃ (LAO) and SrTiO₃ (STO) and in particular of high mobility of two-dimensional (2D) electron gas system (2DES) localized at the oxide/oxide interface has attracted much attention in the past decade. A number of outstanding physical properties have been experimentally observed in the 2DES, which include superconductivity, magnetic properties, a strong Rashba type spin-orbit coupling, and a high charge-to-spin conversion efficiency.

Typically, a LAO film is epitaxially grown on TiO₂-terminated (001) STO substrates so as to form a LAO/STO heterostructure.

Epitaxial growth of a film on a monocrystalline substrate generally requires a good crystallographic lattice match between film and substrate, a similar thermal expansion coefficient and chemical compatibility, as well as other conditions such as minimization of surface roughness, absence of surface defects and high mobility of species at the surface. Epitaxial growth of oxide films on a substrate that are structurally compatible and have cubic or pseudo-cubic lattice but different lattice constants is referred to as "strain engineering". When the lattice constant of the film is dissimilar to the lattice constant of the substrate, compressive or tensile strain is induced within the thin film's crystal structure, as the structure of the film tries to adapt to the structure of the substrate. For LAO and (001) STO an in-plane lattice mismatch at room temperature of about 3% is present, which implies a biaxial tensile strain in the LAO growing film. This in turn results in the building up of elastic energy with the increase of film thickness. Typically, a gradual strain relaxation takes place through the nucleation of misfit dislocations on the surface and their propagation to the film-substrate interface.

A widely used method for fabricating LAO/STO heterostructures is Pulsed Laser Deposition (PLD).

Much scientific work has been focussed on experimental observation and modelling of the LAO/STO interface. L. Qiao et al. in "Thermodynamic instability at the stoichiometric LaAlO3/SrTiO3(001) interface", J. Phys. Condens. Matter 22 (2010) 312201, study LAO films grown on TiO₂-terminated (001) STO substrates by off-axis PLD at an energy of 300 mJ, substrate temperature of 700°C and oxygen partial pressure maintained at 10 mTorr during deposition. Samples exhibited strong cation intermixing. First principles calculations and statistical modelling predicted that the vast majority of intermixed configurations which eliminate the interface dipole are more stable than the abrupt configuration at 300 and 1000 K. The authors concluded that cation intermixing is thermodynamically preferred, even for stoichiometric LAO epitaxial films with excellent structural quality.

In the formation of LAO/STO by PLD, the gas pressure, typically represented by the oxygen partial pressure in the deposition chamber, p(O₂), and the substrate temperature have been considered to have an influence on the film quality.

Woo Seok Choi et al. in "Atomic Layer Engineering of Perovskite Oxides for Chemically Sharp Heterointerfaces", Adv. Mater. 24, 6423-6428 (2012), studied interface formation and strain evolution during the initial growth of LAO on STO by PLD, in search of a means for controlling the atomic-sharpness of the interfaces. Experimental results showed that growth of LAO at a high oxygen pressure (10⁻² Torr) dramatically enhances interface abruptness. A 125 u.c. (equivalent to 47 nm) LAO film on STO grown at high pressure exhibited a severe delamination and cracking of the film, whereas delamination was not observed at low P(O₂) (10⁻⁶ Torr). Authors observed that one monolayer LAO grown at high pressure acted as "shielding layer" and a LAO film could be grown at low pressure up to a thickness of 50 nm.

Theoretical conditions of vertical cracking in epitaxial films have been analysed by S. Lee et al. in "Analysis of vertical cracking phenomena in tensile-strained epitaxial film on a substrate: Part I. Mathematical formulation", International Journal of Solids and Structures 43 (2006) pp. 3401-3413.

The indirect effect of oxygen background gas on La/AI ratio during the growth of LAO films by PLD in a pressure range between 10⁻³ and 10⁻¹ mbar was analysed by A. Sambri et al. in "Plasma dynamics and cations off-stoichiometry in LaAlO3 films grown in high pressures regimes", Journal of Applied Physics 120, 225306 (2016). Rutherford Backscattering studies of LAO samples grown in the investigated pressure range revealed a pressure dependent La/AI content in the films.

Although scientific results have made the LAO/STO 2DES a promising candidate for new generation electronic devices in fields such as spintronics, microelectromechanical systems and quantum technologies, the consolidated use of silicon as a technological platform for the manufacture of large-scale devices poses several challenges to the development of electronic devices based on perovskite 2D heterostructures. The dissimilar nature of silicon in terms of chemistry, structure and thermal expansion implies the need for complex growth processes to preserve high crystalline quality, which are generally not easily applicable on an industrial scale. An early overview on the integration of monolithic integration of oxides on silicon is given by Reiner, J. W. et al. in "Crystalline Oxides on Silicon", Adv. Mater. 22, 2919-2938 (2010).

More recently, Di Lu et al. in "Synthesis of freestanding single-crystal perovskite films and heterostructures by etching of sacrificial water-soluble layers" by, Nat. Mater. 15, 1255-1260 (2016), presented a method to create freestanding perovskite membranes by epitaxial growth by PLD of water-soluble Sr₃Al₂O₆ on perovskite substrates, followed by in situ growth of STO (001) or La_{0.7}Sr_{0.3}MnO₃ films and of superlattices. Sr₃Al₂O₆ acted as sacrificial thin film layer and upon its removal single-crystalline 2D membranes were produced, providing the opportunity to transfer them onto a different support.

The Applicant has noted that the growth of a sacrificial layer of Sr₃Al₂O₆, which act as template for the following growth of the desired perovskite film and the release of the membrane by immersion of the sample in water, increases process complexity.

The Applicant has observed that a suitable selection of the growth parameters allows a dislocation-free epitaxial growth of LAO films at thicknesses much greater than the typical thickness associated with nucleation of dislocations. In particular, inventors have observed that if at least the partial oxygen pressure and the laser fluence are selected within a suitable range of values, the strain state of the LAO film grown on the STO substrate appears to be preserved well beyond the typical thickness at which strain relaxation occurs.

In particular, the inventors recognised that, when the LAO film is epitaxially grown within specific growth parameters to a thickness equal to or exceeding a certain thickness, herein indicated as detachment thickness value, free-standing thin-film LAO/STO heterostructures are formed on an underlying portion of the STO substrate.

An aspect of the present disclosure concerns a process of fabricating free-standing LaAlO₃/SrTiO₃ (LAO/STO) heterostructure membranes by pulsed laser deposition, the process comprising:
- placing a STO monocrystalline substrate having a substrate surface in a processing chamber under vacuum and containing oxygen gas at an oxygen partial pressure, and
- epitaxially growing a LAO film on the substrate surface by pulsed laser ablation of a LAO target by a pulsed laser beam, while the STO substrate is at a substrate temperature of 660°C to 800°C, the target being placed in the processing chamber to face the substrate surface,
wherein during growth of the LAO film the pulsed laser beam has a laser pulse fluence on the LAO target of 1.5 J/cm² to 3.0 J/cm² and the oxygen partial pressure inside the processing chamber is of 0.5x10⁻³ mbar to 5.0x10⁻² mbar.

Preferably, the laser fluence is of 1.8 to 2.5 J/cm².

Preferably, the oxygen partial pressure within the processing chamber is from 1x10⁻² to 5x10⁻² mbar.

Preferably, epitaxially growing the LAO film is up to a final thickness value of the LAO film of 25 nm to 500 nm. More preferably, the final thickness value of the epitaxially grown LAO film is of 50 nm to 500 nm.

In embodiments, the final thickness of epitaxially grown LAO film is of at least 60 nm to 500 nm.

Preferably, epitaxial growth of the LAO film is stopped when the film thickness has reached the final thickness value.

Preferably, after stopping epitaxial growth, the process comprises removing the LAO/STO heterostructure from the processing chamber to expose it in an ambient atmosphere.

Preferably, the process comprises, after epitaxial growth, annealing the sample at a temperature from 400°C to 500°C in an oxygen partial pressure ranging from 50 mbar and 1 bar. Preferably, annealing is for a time from 10 to 90 minutes, more preferably from 20 to 60 minutes.

Annealing may be carried out in the processing chamber or in an external oven.

In an example, annealing is performed within the PLD chamber, at 500°C, in 200 mbar O₂ partial pressure for 30 min.

Preferably, after stopping epitaxial growth and annealing in the processing chamber, the process comprises removing the LAO/STO heterostructure from the processing chamber to expose it in an ambient atmosphere.

Without wishing to be bound by any theory or explanation, inventors believe that, within the above specific growth parameters, when the film growth continues beyond typical thicknesses associated with film strain relaxation, a vertical fragmentation of the LAO film takes place, which extends through the LAO/STO interface to eventually lead to the detachment of free-standing heterostructures of LAO/STO, subsequent to the creation of substantially horizontal fractures in the STO substrate. With increasing thickness of the LAO film, epitaxial growth of the LAO film is believed to proceed up to a cut thickness consistent with the formation of cracks on a surface of the growing LAO film and propagating through the LAO film. Then, growth is continued leading to the formation of a fractured surface, partially or totally covered by free-standing LAO/STO membranes from a remaining underlying portion of the STO substrate.

Typically, a plurality of LAO/STO membranes were found upon exposure of the heterostructure at the ambient atmosphere after epitaxial growth, e.g. by taking out the sample(s) from the processing chamber after growth.

Preferably, epitaxially growing the LAO film is up to a final thickness equal to or larger than a detachment thickness value, t_{det}, of at least 25 nm. Preferably, the detachment thickness value, is comprised between 25 nm and 60 nm.

Preferably, epitaxial growth of the LAO film is stopped when the final thickness of the LAO film is equal to or larger than the detachment thickness value.

Preferably, the substrate temperature during epitaxial growth of the LAO film is of 700°C to 750°C.

Preferably, the substrate temperature is maintained constant during epitaxial growth of the LAO film.

Preferably, the processing chamber is a vacuum chamber kept at a base pressure below 1x10⁻⁶ mbar, more preferably not exceeding 1x10⁻⁷ mbar, even more preferably not exceeding 1x10⁻⁸ mbar. For example, the base pressure ranges from 1x10⁻⁹ mbar to 1x10⁻⁷ mbar.

Preferably, epitaxial growth of the LAO film is performed while maintaining the same growth parameters.

The target has a target surface defining a target plane.

Preferably, the process further comprises, before placing a STO substrate, providing a pulsed laser deposition apparatus comprising the processing chamber, a target holder placed in the processing chamber and a substrate holder, wherein the ablation target is placed on the target holder, the substrate is placed on the substrate holder, the substrate surface being the exterior (upper) surface of the substrate, and the target holder and the substrate holder being positioned such that the substrate surface and the target surface face one another.

The substrate is placed at a substrate-target distance, d_{T-S}, from the target. Preferably, the substrate-target distance is from 30 mm to 45 mm, more preferably from 36 mm to 38 mm.

Due to film growth, the substrate surface defines an interface between the STO substrate and the LAO film.

Preferably, the pulsed laser beam is an excimer pulsed laser beam.

Preferably, the pulsed laser beam is from an excimer laser source, in particular a KrF excimer laser source operating at a wavelength of 248 nm.

In particular, epitaxially growing LAO films comprises irradiating a spot area of the target with the pulsed laser beam to generate a plasma plume of ablated target material and depositing such material on the substrate surface.

Preferably, the target is a LAO single crystal, more preferably a (001) oriented single LaAlO₃ crystal.

Preferably, the pulsed laser beam hits the target at an angle of 45° with respect to the target surface.

Preferably, the pulse repetition rate of the laser beam is of 1 to 10 Hz, more preferably of 1 to 5 Hz.

The plasma plume extends mainly along a direction normal to the target surface.

The substrate surface defines a substrate plane. Preferably, the substrate and the target are positioned faced to one another in a way that substrate surface and the target surface lie in substantially parallel planes. Typically, the plasma plume mainly extends in a normal direction to both the target surface and the substrate surface.

Preferably, the laser spot area on the target surface is of 0.5 mm² to 3.0 mm².

Preferably, the SrTiO₃ substrate is a TiO₂-terminated (001)-oriented substrate.

The thickness values of the grown film may be represented by the number of unit cells (u.c.), namely the number of monolayers having as unit the crystal lattice parameter in the growth direction. For LAO crystal, a unit cell corresponds to 0.379 nm (unrelaxed). The thickness may be represented by a metric unit, e.g. nanometer.

Following calibration of the deposition rate for the LAO film epitaxy, to determine, for specific growth parameters, the number of unit cells grown per laser pulse, the final thickness value of the LAO film may be associated with a final growth time, i.e. the duration of the epitaxial growth process to reach the number of unit cells corresponding to the final thickness of the LAO film. Alternatively or in addition, the final thickness value of the LAO film may be associated with a total number of laser pulses. Preferably, when the value of the final thickness is determined to be achieved, growth is stopped. End of the growth process may be stopped automatically, for example by automatically switching off the laser after a predetermined time lapse.

The process may comprise, during epitaxial growth, in-situ monitoring the thickness of the LAO film deposited on the substrate.

Monitoring in real-time the growing film may be carried out with high energy electron diffraction (RHEED) technique. As generally known, RHEED may allow control of the thickness of the grown layer with precision of one monolayer.

Preferably, the thickness, e.g. the number of unit cells layers, of the epitaxially grown LAO film is determined with RHEED technique. In particular, monitoring of the number of u.c. layers of the LAO film during growth is based on analysis of the periodic oscillations of the intensity of diffraction spots in diffraction patterns with increasing layer thickness.

In an embodiment, the process comprises analysing the growth process with RHEED technique, wherein analysing comprises:
directing an electron beam at the growing LAO film at a grazing angle so as to create diffraction patterns from a diffracted electron beam reflected from an exterior surface of the LAO film;
continuously recording intensity oscillations in the diffraction pattern as a function of time to determine instantaneous values of thickness of the LAO film during growth;
comparing the determined instantaneous thickness values with a preset final thickness value;
   - continuing growth of the LAO film if the determined thickness is less than the final thickness value, and
   - stopping growth if the grown thickness is equal to the final thickness value.

Further to monitoring of the thickness of the LAO film during growth, RHEED technique may be used to monitor the lattice structure of the LAO film surface.

Typically, the RHEED technique detects the structure of the uppermost unit cell layer.

The present disclosure relates also to a free-standing heterostructure membrane fabricated in accordance with a process consistent with the present disclosure.

A second aspect of the present disclosure relates to a free-standing heterostructure membrane, comprising.
- a SrTiO₃ single-crystal layer having a lower surface, and
- an epitaxial LaAlO₃ film on the SrTiO₃ layer so as to form an interface between the LaAlO₃ film and the SrTiO₃ layer, the LaAlO₃ film having a thickness of from 25 to 500 nm, the LaAlO₃ film having an upper surface,
wherein the heterostructure membrane has opposing surfaces, a membrane upper surface corresponding to the upper surface of the LaAlO₃ film and a membrane lower surface corresponding to the lower surface of the SrTiO₃ layer.

Preferably, the heterostructure membrane is a bilayer membrane.

Preferably, the thickness of the LAO film is from 50 nm to 500 nm.

The membrane upper surface and the membrane lower surface may be curved surfaces, the membrane upper surface having a concave shape and the membrane lower surface having a convex shape with respect to a centre of curvature.

The heterostructure membranes may have a shape that can be approximated to a portion of spherical shell.

Each of the opposing curved surfaces delimiting the membrane has a radius of curvature.

Preferably, the membrane opposing curved surfaces have radius of curvature of from 5 µm to 20 µm.

In embodiments, the membrane upper surface and the membrane lower surface have substantially the same radius of curvature.

The LAO layer is epitaxially grown on the STO layer of the heterostructure membrane.

The thickness of the STO layer may range from 25 nm to 500 nm.

Preferably, the heterostructure membrane has a thickness of from 50 nm to 1000 nm. In embodiments, the thickness value of the STO layer is similar, such as approximately the same, to that of the LAO film.

The membrane upper surface has a surface area. The surface area may be comprised from 0.2 µm² to 100 µm². The surface area may be determined by means of different techniques, for example by scanning electron microscopy.

The edges of the membranes may be substantially aligned with the principal axes of symmetry of the underlying STO layer. For a STO single crystal (001) oriented, the principal axes may be typically the in-plane respective [100] and [010] directions.

Advantageously, the process for producing heterostructure membranes according to the present disclosure may be carried out in a single-step deposition by means of laser pulses, by carrying out the growth at specific process conditions up to a thickness at which LAO/STO heterostructure membranes detach themselves from an underlying portion of the STO substrate.

The LAO/STO membranes produced by the process according to the present disclosure may allow the integration of perovskite 2D heterostructures on silicon wafers.

Advantageously, membranes typically exhibited metallic interfacial conductivity at the LAO/STO interface.

In embodiments, the free-standing LAO/STO heterostructure membrane may exhibit a metallic behaviour of the interfacial sheet resistance, with typical two-contact resistance values ranging from 50 to 300 KΩ at 300K and from 2 to 25 KΩ at 4K.

Further characteristics and advantages will now be described in more detail hereinafter with reference to the accompanying drawings, in which some, but not all embodiments of the invention are shown. Drawings illustrating the examples are not-to-scale schematic representations.

For the purpose of the present description and of the appended claims, except where otherwise indicated, all numbers expressing amounts, quantities, percentages, and so forth, are to be understood as being modified in all instances by the term "about".

Also, all ranges include the maximum and minimum points disclosed and include any intermediate ranges therein, which may or may not be specifically enumerated herein.
Fig. 1 illustrates a schematic representation of a laser ablation apparatus, shown in a top partial section view, which may be used to fabricate the membrane-like heterostructures according to the present disclosure.
Fig. 1a shows some more details of Fig. 1 of the substrate-target geometry.
Fig. 2 is a pictorial representation of the main phases of a conceivable growth process leading to the formation of heterostructure membranes.
Fig. 3 is a pictorial representation of an exemplary free-standing heterostructure membrane.
Fig. 4 shows a specular (0,0) RHEED spot intensity evolution versus time (seconds) during growth of a 30 nm-thick LAO sample grown at a laser fluence of 1.0 J/cm². Right inset reports an AFM image of a surface portion of the sample, while the left inset plots an x-ray diffraction (XRD) pattern.
Fig. 5 shows a specular (0,0) RHEED spot intensity evolution versus time during growth of a 30 nm-thick LAO sample grown at a laser fluence of 2.5 J/cm², in accordance to an example. Right inset reports an AFM image of a surface portion of the sample, while the left inset plots an x-ray diffraction (XRD) pattern.
Fig. 6 shows a specular (0,0) RHEED spot intensity evolution versus time for the first 600 seconds growth of a LAO film, in accordance with an example. The left inset of the figure shows the RHEED signal versus time up to 3600 seconds (1 hour deposition), while in the right inset a RHEED diffraction pattern is reported.
Fig. 7 shows a cross-sectional electron microscopy image of the sample according to the example of Fig. 6.
Fig. 8 reports scanning electron microscopy (SEM) images a) to d) of portions of the top surface of exemplary samples following epitaxial growth of a LAO film on a STO substrate consistently with the present disclosure.
Fig. 9 is a SEM image of another region of sample shown in inset a) of Fig. 8.
Fig. 10 is a cross-sectional TEM image of a sample in an example consistent with the present disclosure.

In general, the same reference numeral will be used in different figures for the same or similar elements.

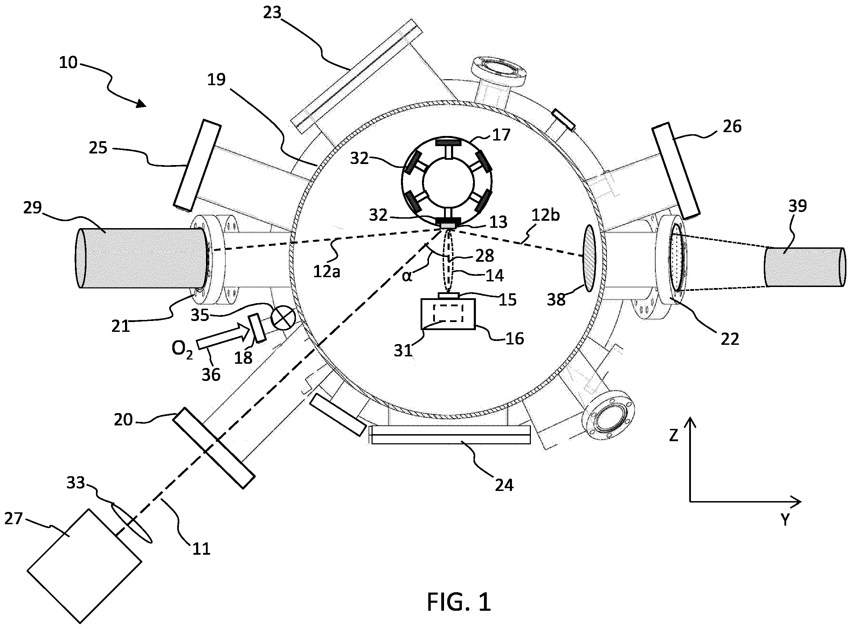

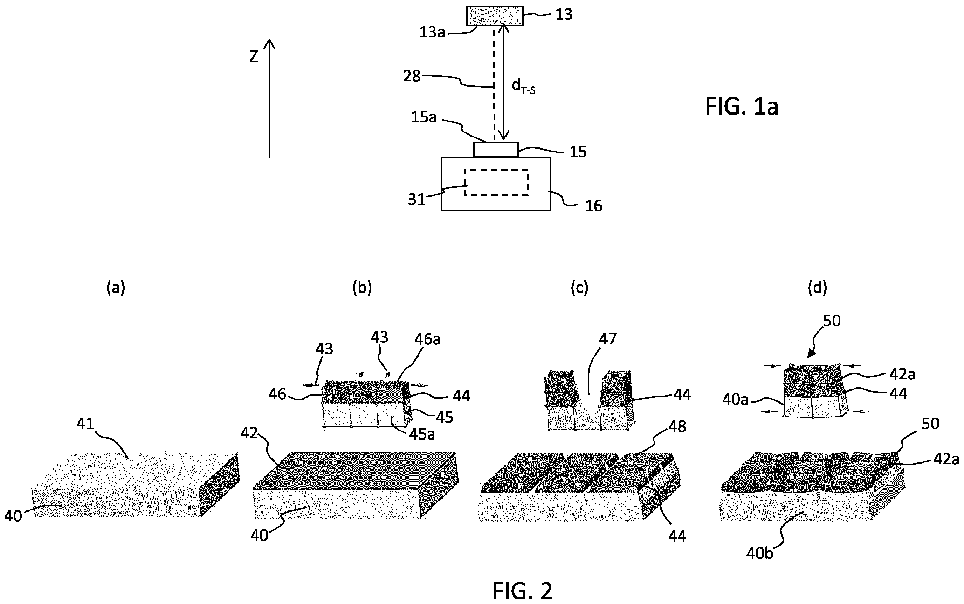

A typical PLD apparatus that may be used to epitaxially grow LAO films on STO substrates is globally indicated with 10 and depicted in Fig. 1. As it is generally known, PLD uses a high-power laser source to excite a target surface. This power density (typically of the order of 100 MW/cm²) provided by the laser shot causes the ablation of a surface layer, which is vaporised and ejected in the form of both neutral and ionised species. The atoms/molecules, but also macromolecules and macroscopic particulates, which are ablated from the target surface, form a transient luminous flux of material generally indicated as plasma plume, which expands away and is directed to a substrate where some of the plasma plume material recondenses to form sub-layers and then layers of a film on a substrate. PLD is performed under vacuum which deliberately contains oxygen when formation of oxide films is desired.

In more detail, laser ablation and deposition of LAO/STO heterostructures take place within a processing chamber 19, typically a cylindrical or spherical chamber having circular cross-section.

The processing chamber is a vacuum chamber, in which vacuum may be created by an ultra-high vacuum (UHV) pump system (not shown), such as a pump system comprising a rotary vacuum pump and a turbomolecular pump used in series. For example, the vacuum chamber is pumped at a base pressure of less or equal to 10⁻⁷ mbar, for example between 1x10⁻⁹ and 1x10⁻⁷ mbar. Oxygen gas (O₂) delivered by a gas source, schematically indicated by arrow 36 is introduced in the vacuum chamber 19 through a gas inlet 18 equipped with a throttle valve 35. Oxygen in-flow may be adjusted by means of the throttle valve or mass flow controller 35 so as to keep a background oxygen partial pressure within the processing chamber 19 at a desired value.

An external laser source 27, in particular an ultraviolet (UV) excimer laser source, is configured to emit a pulsed laser beam 11 which is focussed by a focussing lens 33 and enters the vacuum chamber 19 through a first port 20 having a window transparent to UV light. Preferably, the laser source 27 is a short wavelength excimer laser. In particular, the laser source emits a pulsed laser beam at 248 nm.

A second port 23 is fit with a rotary feedthrough device having a rotatable shaft (not indicated) penetrating in the processing chamber 19 to be engaged with a rotatable carousel 17 comprising one or more target holders 32, such as target tables. In particular, an ablation target 13 having a target surface 13a (Fig. 1a) defining a target plane is mounted on a target holder 32 to be positioned to receive the laser beam. The target 13 is struck by the pulsed laser beam 11 focussed on the target surface. Preferably, during deposition, the target rotates about an axis perpendicular to the target surface 13a to distribute the laser shots on a wider area and prevent the formation of holes in the target. The ablation target 13 is a single crystal LAO, such as a bulk single crystal LaAlO₃(100).

Typically, the pulsed laser beam 11 strikes the target 13 at an angle α of 45° with respect to the target surface 13a or, as indicated in the figure, to the normal direction 28 (dashed line) to the target plane.

Due to the laser ablation, a plasma plume 14 is formed, which expands mainly in the normal direction 28 to the target plane.

A STO substrate 15 is placed or mounted on a substrate holder 16 which is positioned so as to face the target holder 32 and in particular the target 13, across a distance, indicated as substrate-target distance, d_{T-S}, taken along the normal direction 28 (Fig. 1a). An electric heater 31 heats the substrate holder 16 and thus the substrate 15. The heater 31 is set at a temperature, indicated as the substrate temperature, Tₛ, typically maintained constant during the deposition process. A thermocouple (not shown) inserted in the holder may be used to measure the substrate temperature. The STO substrate 15 has a surface, indicated as substrate surface 15a (Fig. 1a), facing the target and defining a substrate plane. The substrate 15 is positioned in a way that the substrate plane is substantially perpendicular to the normal direction 28 and thus to the plasma plume main direction. Preferably, the target surface 13a and the substrate surface 15a are lying on substantially parallel planes.

For the setting and monitoring of the deposition parameters within the PLD processing chamber an electronic control system is typically employed (not indicated in the figure). Typically and in ways per se known, the electronic control system comprises one or more electronic processors operatively connected to a plurality of sensors, such as temperature and pressure sensors placed within the processing chamber 19. The one or more electronic processors are configured to receive data indicative of the measured parameters from sensors and to control deposition parameters, to set parameter values and/or to reduce variations of parameter values, for example for maintaining a constant substrate temperature during the deposition process. The electronic control system may control electro-mechanical devices for movement of parts (not shown in Fig. 1) within and in/out the processing chamber 19. To this end and in ways per se known, one or more processors may be operatively coupled to a plurality of actuators for driving electro-mechanical devices, such as inlet and outlet valves and robotic actuators for moving samples or sample holders.

The PLD apparatus 10 may comprise windows 24, 25 and 26 to allow visual contact to the process from different angles and from two sides and/or to allow access to the processing chamber.

Due to the target to substrate geometry during deposition, the substrate-target distance, d_{T-S}, is typically taken along the normal direction 28, which is herein indicated also as the Z-axis which corresponds to the main growth direction of the LAO film. A XY plane perpendicular to the Z-axis is assumed to define the substrate plane of the substrate surface 15a (Fig. 1a). According to this annotation, the plasma plume is expanding mainly in the Z direction (axes Y, Z represented in Fig. 1).

A parameter that characterises the ablation and thus the deposition is the laser energy density of the laser beam, often represented by the laser fluence or laser pulse fluence, which denotes the optical energy focused on a unit area of the target surface within each pulse, namely Joule per unit area, e.g. J/cm². Therefore, the laser fluence can be varied by changing the optical energy of the laser pulses and/or the dimension of the spot area on the target surface 13a.

The plasma plume has a maximum length along the direction of main extension. The maximum length largely depends on the partial O₂ pressure, p(O₂), and on the laser fluence F, albeit indirectly as the latter magnitude strongly influences the initial front velocity of ablated species and the driving mass of material ablated per laser pulse. During growth, oxygen is present in the processing chamber 19, whereas no other gases are intentionally introduced in the processing chamber.

The background partial oxygen pressure, p(O₂), is set at a value comprised between 0.5x10⁻³ and 5x10⁻² mbar, preferably between 1x10⁻² and 5x10⁻² mbar.

Preferably, the heater 31 is set at a substrate temperature, Tₛ, comprised between 660°C and 800°C, which is maintained constant during the deposition process. Preferably, the substrate temperature is comprised between 700°C and 750°C.

The pulsed laser beam 11 hits the target 13 with a laser pulse fluence set at a value comprised between 1.5 and 3.0 J/cm², preferably comprised between 1.8 and 2.5 J/cm².

Preferably, the laser spot area on the target surface is of from 0.5 to 3.0 mm².

Preferably, the substrate-to-target distance d_{T-S} is of from 3 to 5 cm.

In an embodiment, a monitoring of the epitaxial growth of the monocrystalline LAO films during the PLD process is carried out by reflected high energy electron diffraction (RHEED). To this end, the PLD apparatus 10 comprises a RHEED instrument (not shown in detail) installed in the processing chamber 19. As known in the art, the RHEED instrument comprises an electron gun 29 configured to emit a narrow electron beam, represented with a dashed line 12a in Fig. 1, which is sent to the sample surface at grazing incidence through a window of RHEED input port 21 of the processing chamber 19. The incident beam is reflected/diffracted as a secondary electron beam 12b which hits a fluorescent screen 38, such as a phosphor screen, arranged in the processing chamber 19. Fluorescent light, produced by electron impingement, exits a RHEED output port 22 through an optical window to be imaged by a camera 39, such as CCD video camera, arranged outside the processing chamber 19.

As per se known, the secondary beam 12b is observed as periodic intensity oscillations of the brightness of individual diffraction spots on a fluorescent screen, namely as a diffraction pattern. The intensity oscillations are caused by the layer-by-layer growth and their period corresponds to the growth time of a unit cell layer of the film. Among the information that can be derived by RHEED is the growth rate, the number of deposited unit cells, and the surface structure. RHEED software typically installed in the RHEED instrument provides real-time monitoring and possibly analysis of the epitaxial growth process. Typically, detected diffraction patterns are recorded. The diffraction pattern and the instantaneous values of unit cell layers, and possibly other information derived from the RHEED diffraction pattern may be rendered to a user by any means, such as a display. For example, as customarily, a video signal as output signal of the video camera 39 is directed through a computer interface of a computer to a video monitor. Images, which are typically matrices of pixels, are stored in a memory of the computer. Elements of RHEED software/computer and/or rendering elements are not shown in the figures.

Data indicative of the periodic intensity oscillations may be processed by an electronic processor in the RHEED software (e.g. computer) to determine in real-time the thickness of the film, which is typically represented by the number of unit cell layers. The user may stop the growth process when the number of unit cells layers reaches a final value corresponding to a certain thickness, which may correspond to or be larger than a detachment threshold thickness value, t_{det}.

Additionally or in alternative, the instantaneous values of unit cell layers during epitaxial growth are compared, by an electronic processor, to a predetermined thickness value, such as a final thickness value for the LAO film, and, when the predetermined value has been reached, the growth process is automatically stopped. In consideration of the typical linear relationship between number of unit cell layers and time during epitaxial growth, growth time may be also used to determine the end of the growth process.

In an embodiment, the process of fabricating free-standing LAO/STO heterostructure membranes further comprises analysing the growth process with RHEED technique, wherein analysing comprises:
- directing an electron beam at the growing LAO film at a grazing angle so as to create diffraction patterns from a diffracted electron beam reflected from an exterior surface of the LAO film, and
- continuously recording intensity oscillations in the diffraction pattern as a function of time to determine instantaneous values of thickness of the LAO film during growth.

Preferably, the process comprises comparing the determined instantaneous thickness values of the LAO film with a threshold thickness value, such as the final thickness value, to continue growth of the LAO film if the determined thickness values are less than the threshold thickness value and to stop growth if a grown thickness value is equal to the threshold thickness value.

Monitoring the crystal structure of the monocrystalline LAO film may also be possible from the analysis of RHEED diffraction patterns.

After epitaxial growth of the LAO film has been stopped, the substrate 15 is taken out from the processing chamber 19, so as to be exposed to an atmospheric pressure.

Preferably, after epitaxial growth, the substrate 15 (and thus LAO/STO heterostructure) is annealed at a temperature from 400°C to 500°C, in an oxygen partial pressure ranging from 50 mbar and 1 bar.

Preferably, annealing time is of from about 20 minutes (min) to about 90 min, more preferably from 20 min to 60 min.

In an embodiment, after epitaxial growth and before removal of the substrate 15 from the processing chamber 19, the process comprises setting the substrate temperature Tₛ at an annealing temperature comprised between 400°C and 500°C, while the oxygen partial pressure is set at a value comprised between 50 mbar and 1 bar.

Annealing may be performed in an external oven, under flowing oxygen, outside the processing chamber.

Figure 2 portrays pictorially a conceivable evolution in time of the growth process consistent with the present disclosure, in particular under relatively high laser fluence and relatively high partial oxygen pressure.

A STO substrate 40 having a substrate surface 41, preferably a (001)-oriented STO substrate, is provided (phase a). The material ablated from the LAO target is deposited on the substrate surface 41 producing the growth of an epitaxial film 42 of LAO on substrate 40. LAO and STO have an in-plane lattice mismatch of about 3%, which causes an in-plane tensile strain in the LAO film. The strain condition in the LAO/STO heterostructure is conceptually indicated by a portion 45 of lattice unit cells 45a of the substrate 40 and a portion 46 of lattice unit cells 46a of the epitaxial film 42, the latter being under tensile strain represented by arrows 43 (phase b). Numeral 44 indicates the LAO/STO interface, at the position of the substrate surface 41. As the thickness of the LAO film increases, the strain accumulated in the LAO film 42 and thus the elastic energy is expected to build up. When the thickness of the grown LAO film 42 reaches a certain thickness value (phase c), multiple cracks appear at the surface of the LAO film resulting in a fragmentation of the LAO exterior surface, wherein the cracks extend vertically through the LAO film as vertical fractures 47. Remarkably, by continuing the process of epitaxial growth, the vertical fractures 47 run through the LAO/STO interface 44 to extend in an upper portion of the STO substrate, such as for a thickness up to few hundred nanometres. Without wishing to be bound by any theory or explanation, the generation of deep vertical fractures may be due to a sudden relaxation of the accumulated strain in the grown LAO film.

Continuation of epitaxial growth of the LAO film 42 beyond the generation of deep vertical fractures leads to the formation of horizontal fractures in the LAO/STO heterostructure at a depth in the STO substrate in most cases approximately corresponding to the depth of the vertical fractures, as depicted in phase (d) of Fig. 2.

The formation of horizontal fractures cause the detachment of a plurality of free-standing thin-films of LAO/STO 50, thus thin-film LAO/STO heterostructures, as bilayer LAO/STO membranes. Each of the heterostructure membranes 50 is formed by a LAO epitaxial film 42a on a STO layer 40a detached from a remaining portion 40b of the original STO substrate 40.

Without wishing to be bound by any theory or explanation, the inventors believe that, at specific growth conditions, the elastic energy built-up in the film abruptly relaxes to give raise to vertical fractures. In many cases, vertical fracturing of the samples was observed to mainly occur along crystallographic planes of LAO and STO, and notably the horizontal fractures did not occur at the film-substrate interface but in the substrate itself allowing the detachment of "hetero-membranes", namely free-standing thin-film LAO/STO heterostructures.

Generally, by "vertical" or "vertically", referred to the heterostructures, it is meant a vertical direction substantially perpendicular to the substrate surface (i.e., substrate plane) and thus, due to the nature of epitaxial growth, to the film surface. For example, substantial perpendicularity of the vertical fractures indicates that the vertical direction and the substrate surface plane are aligned within an angle of between approximately 80 degrees and 120 degrees, in particular between 90 degrees and 110 degrees, often with a deviation, if present, of a few degrees from 90°. Variance from a 90° perpendicularity may change with the depth of the fractures. In conditions consistent with embodiments of the present disclosure, if the surface of the monocrystalline STO substrate is in a plane parallel to the (001) plane, the fractures typically tended to lengthen vertically from the LAO surface along the (100) or (010) planes. The cuts extended vertically through the LAO/STO interface (i.e. the STO surface) into an upper vertical portion of the STO substrate.

For (001) STO substrates, the horizontal cuts causing detachment typically take place along the (001) plane. In some instances, before the horizontal propagation of the cuts causing detachment, cuts may comprise an oblique section between the vertical cut section and the horizontal cut section. The oblique section of the cuts is typically along the (110) plane for a (100) STO substrate.

The thickness of grown LAO film at which the detachment of heterostructure membranes is indicated as the detachment thickness value, t_{det}.

The process growth may stop when the thickness of the grown LAO film, t_{LAO}, is at least equal to the detachment thickness, t_{det}, and in general equal to or larger than 25 nm

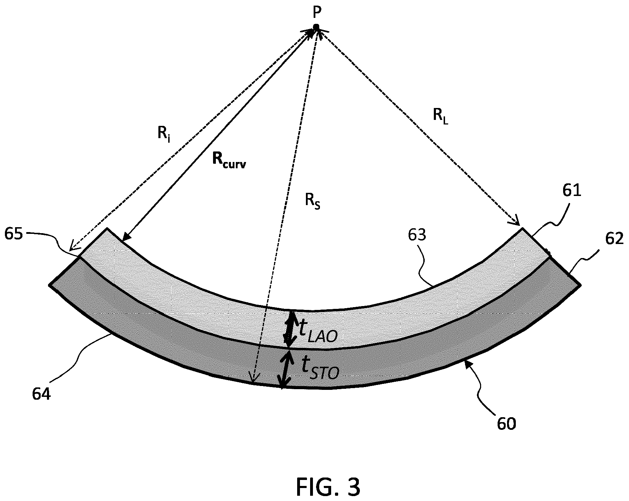

Figure 3 is a pictorial representation of a free-standing typical heterostructure membrane obtained by a process in accordance with the disclosure. A LAO/STO heterostructure membrane 60 comprises or consists of a SrTiO₃ single-crystal layer 62 and an epitaxial single-crystal LAO film 61 on the STO layer 62 so as to form an interface 65 between the LAO film 61 and the STO layer 62.

The heterostructure membrane 60 has a membrane upper surface 63 corresponding to the upper surface of the LAO film 61 and a membrane lower surface 64, opposed to the membrane upper surface, corresponding to the lower surface of the STO layer 62.

Typically, the heterostructure membranes exhibit opposite curved surfaces 63, 64. Without wishing to be bound by any explanation, the tendency of bending of the heterostructure membranes may be due to the difference in lattice constants in the two layers geometrically sharing a same interface 65, namely at the STO substrate surface. The STO layer and LAO layer of each heterostructure membrane can be seen as two membranes, respectively obtained by assigning, perpendicular to interface 65, a respective finite thickness t_{STO} and t_{LAO}. Left separated, the STO and LAO "membranes" would be flat and the STO layer would have larger linear dimensions than the LAO beam by about 3%. Upon epitaxial growth, the constraint applied by each of two layers lead to the bending of the composite membranes, the LAO part becoming convex, and the STO becoming concave, with respect to their interface 65. As a consequence, at the LAO part, the membrane upper surface 63 is concave, whereas the membrane lower surface 64 is convex. "Convex" or "concave" is defined with respect to the interface 65 of the LAO/STO heterostructure membrane 60.

Concavity/convexity of the membrane upper and lower surfaces may be represented by a respective radius of curvature, R_{L} and R_{S} (radii of curvature are indicated in Fig. 3 with respect to a center of curvature P).

On a first approximation, the radius of curvature of the upper membrane surface 63, R_{L}, is R_{L}= (Rᵢ - t_{LAO}) and the radius of curvature of the lower membrane surface 64, R_{S}, is R_{S}= (Rᵢ + t_{STO}), where Rᵢ is the radius of curvature of the LAO/STO interface 65.

In embodiments, Rᵢ is 20 to 30 times the value of tₘ, where tₘ is the thickness of the membrane. On a first approximation, the radii of curvature R_{L} and R_{S} exhibit similar values, typically within 5%, with respect to the centre of curvature P. Therefore, by approximating the membrane by an osculating spherical cap, a radius of curvature of the heterostructure membrane, R_{curv}, can be defined as the spherical radius of the membrane. Preferably, the radius of curvature is of from 5 µm a 20 µm.

In many examples, the thinner is the epitaxially grown layer, the smaller may be the radius of curvature of the membrane surfaces.

Preferably, the LAO epitaxial film has a final grown thickness t_{LAO} of 25 nm to 500 nm, more preferably from 50 nm to 500 nm.

Thickness of the STO layer, T_{STO}, of the hetero-membrane may depend on the process parameters during epitaxial growth of the LAO on the STO substrate which led to detachment of the membranes. The thickness of the STO layer may range from 25 nm to 500 nm.

In embodiments, the thickness of the STO layer has approximately the same value as the thickness of the LAO film.

Typically, the thickness of the LAO film is uniform across the film surface, i.e. the upper membrane surface.

The thickness of the STO underlying layer 62 may be substantially uniform or may exhibit a non-uniform thickness. In the second case, the non-uniformity may vary of 30-40% across the membrane lower surface.

Preferably, the thickness of the heterostructure membrane, tₘ = (t_{LAO} + T_{STO}) is equal to or larger than about 50 nm. Preferably, tₘ is equal to or smaller than 1000 nm.

Typically, samples with LAO/STO heterostructures exhibited a surface partially or totally covered by flakes for LAO films grown at a final thickness exceeding 25 nm. Generally, at increasing laser fluence during LAO film growth, the fraction of the surface covered by flakes increased for epitaxial depositions with increasing thickness above the detachment thickness value.

Typically, samples with LAO films grown at a fluence exceeding 1.5 J/cm² and thicker than about 50 nm had almost 100% of the surface covered by flakes.

### Comparative example

Several samples were prepared by depositing LAO films by Reflection High Energy Electron Diffraction (RHEED) assisted pulsed laser deposition (PLD). A PLD apparatus of the type described in Fig. 1 was employed. The laser source 27 was a KrF excimer laser operating at λ=248 nm. Commercially available (001)-oriented STO substrates purchased by Crystec GmbH (DE) were employed. The substrate thickness was 500 micron. Prior to deposition, the STO substrates were sonicated in de-ionized water, then chemically etched in a buffered HF solution, in order to obtain a single TiO₂ terminating layer on the substrate surface. The substrates were then annealed to reconstruct the step edges. The method of preparing the STO substrates is described in *"*Influence of the surface treatment on the homoepitaxial growth of SrTiO3", by G. Koster et al., Materials science & engineering B, (B56) 1998, 209-212.

The TiO₂-terminated (001)-oriented STO substrates were transferred in the processing chamber 19 through a magnetic transfer bar (not indicated in Fig. 1) and mounted with a wobble stick on the heatable sample holder 16 set at the substrate temperature of 720°C.

The processing chamber 19 was a UHV chamber with a base pressure of 10⁻⁸ mbar. A single-crystal LaAlO₃ target 13 was placed on a target holder 32 rotating about an axis perpendicular to its surface. The substrate-to-target distance d_{T-S} was set to 37 mm. Once the substrate temperature was stabilised at 720°C, an oxygen flow was introduced in the chamber so as to achieve a stabilised background oxygen pressure of 2x10⁻² mbar.

The pulsed laser beam emitted by the laser source hit (001)-oriented STO substrates with an incidence of 45°. The pulsed laser beam had a pulse width of approximately 20 ns and 3 Hz pulse repetition rate.

The laser parameters and the optics were set to focus the laser on a spot area of 0.8 mm² of the substrate surface. Typical growth rate was of the order of 20 pm/pulse, corresponding to about 1/20 LAO unit cells/pulse. A mask was employed to obtain a homogeneous beam profile on the target surface.

Several samples were prepared with the laser fluence set at a value comprised between 1.0 and 1.3 J/cm². Laser fluence and the other process parameters were maintained constant during the growth process.

After growth of the LAO film, in-situ annealing at 500°C in oxygen partial pressure of 50 mbar was performed for 1h to fully oxidize the samples, thus minimizing the presence of unwanted oxygen vacancies. Samples were then cooled to room temperature at the same pressure conditions held during the deposition process, i.e. 2x10⁻² mbar of oxygen partial pressure, in the processing chamber.

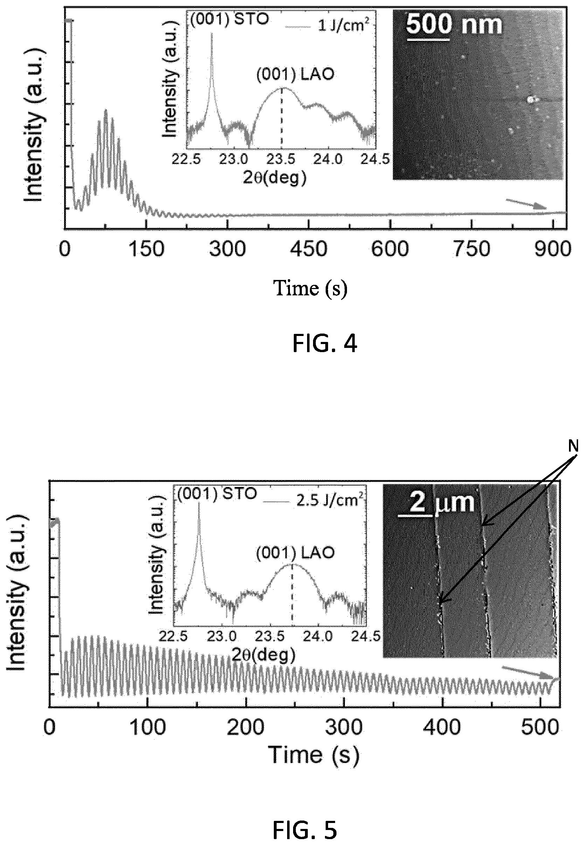

Figure 4 shows an exemplary specular (0,0) RHEED spot intensity evolution versus time during growth of a 30 nm-thick LAO sample grown at a laser fluence of 1.0 J/cm². Damped reflection high-energy electron diffraction (RHEED) oscillations were consistent with growth of smooth film and a relaxed vertical lattice parameter. The right inset in the figure reports an AFM image of a surface portion of a 30 nm thick sample. The AFM image shows that the growth of the LAO film was smooth and layer-by-layer, yet revealing a terraced surfaces. The left inset is an x-ray diffraction (XRD) pattern plotting the intensity vs. scattering angle. Data are consistent with a relaxed vertical lattice parameter c = 0.378 nm and a gradual strain relaxation through dislocation formation.

Ultrasonic wire bonding was used to contact the samples after growth in order to measure their electrical sheet resistance across a temperature range from room temperature to about 10 K. Samples were found to be macroscopically conductive up to a maximum investigated thickness of 120 nm of LAO film.

### Examples

About 50 samples were prepared by a PLD growth process of LAO film by employing the same deposition parameters used in the Comparative Example, in particular p(O₂) = 2x10⁻² mbar, T = 720°C, d_{T-S} = 37mm, except for the laser fluence and final thickness of the LAO film. Final thickness of the LAO epitaxial layer for the investigated samples ranged from 5 nm to 180 nm. Laser fluence and the other process parameters were maintained constant during the growth process. The STO substrates were TiO₂-terminated (001) STO substrates purchased by Crystec GmbH and prepared using the same method employed for the substrates in the Comparative Example. After growth of LAO films, in-situ annealing and cooling were carried out at the same conditions used for the samples of the Comparative Example.

From analysis of the RHEED diffraction pattern, LAO films were observed to grow perfectly epitaxial up to the maximum investigated final thickness of 180 nm.

Vertical cracks were observed in all samples, about 35, grown with thickness of 30 nm or above, while all samples grown up to a thickness less than about 15 nm were crack free. With the generation of vertical cracks, the LAO/STO heterostructures were macroscopically insulating, as checked in Van der Pauw configuration, whereas the crack-free samples were macroscopically conductive.

A plurality of heterostructure membranes detached from an underlying substrate layer were found in all samples when the thickness of the grown LAO layer exceeded 25 nm. Membranes were visible as "flakes" on the surface of an underlying STO substrate layer.

### Example 1

A LAO sample was grown at a laser fluence of 2.5 J/cm² to a final thickness of 30 nm.

Figure 5 shows an exemplary specular (0,0) RHEED spot intensity evolution versus time during growth of the sample. The surface area of the STO substrate on which the LAO film was grown was of about 25 mm². A presence of persistent RHEED oscillations is typically indicative of a steady growth regime until the end of the deposition process. Following cooling and removal of the sample from the processing chamber, the sample was measured by Atomic Force Microscopy (AFM). The right inset of Fig. 5 is an AFM image of the surface of the LAO film at the final thickness of 30 nm. Vertical fractures V (indicated with arrows N) extending horizontally on the LAO surface for lengths exceeding 10 µm could be observed. The left inset of Fig. 5 reports the XRD diffraction pattern of the sample, always after growth. A reduced vertical LAO lattice parameter of c=0.374 nm was measured, which is consistent with tensile in-plane strain. No flakes were observed in this sample in the area investigated by AFM, of the order of 100 µm², orders of magnitude smaller than the entire surface. Other relatively small surface areas of the same sample (not shown in the figure) exhibited flakes on the surface.

### Example 2

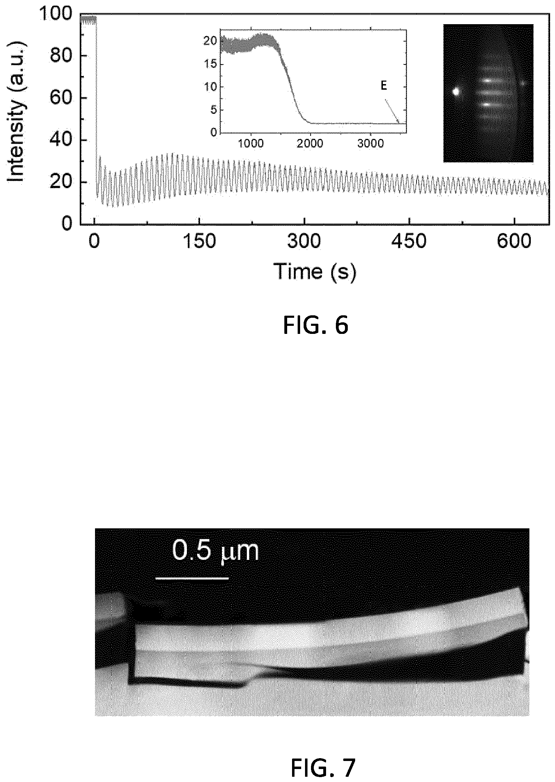

A LAO film was grown under the same conditions of Example 1 on TiO₂-terminated STO(001), but for the fluence that was set at F = 2.0 J/cm². The LAO film was grown to final thickness of 180 nm. Figure 6 reports the first 600 seconds of the time evolution of RHEED signal representing (0,0) spot intensity variations during epitaxial growth of the LAO film according to this Example. The left inset of the figure shows the RHEED signal versus time up to 3600 seconds (1 hour deposition), while in the right inset a RHEED diffraction pattern is reported. The RHEED signal evolution at 1 hour deposition corresponds to the final LAO film thickness of about 180 nm. With reference to the main graph, already after few seconds of growth, a steady state mode was reached, which lasted up to a relatively large thickness of about 85 nm (1500 s). With reference to the left inset of the figure, as deposition proceeded beyond 1500 s, the RHEED signal showed a rapid decrease in intensity and reached a new steady state with relatively low intensity (see arrow E in the left inset). The RHEED streaky pattern provides an indication that the final sample surface was still two-dimensional.

Time evolution of the growth process conceivably followed the qualitative behaviour pictorially described in Fig. 2 and, at the end of the process, following cooling and removal of the sample from the processing chamber, a plurality of LAO/STO membranes covered the surface of a STO substrate layer. Figure 7 shows a low resolution cross-sectional TEM image of a typical membrane of the sample after epitaxial growth of the LAO film and in-situ annealing. The heterostructure membrane had a radius of curvature, R_{curv}, of 8 µm.

### Example 3

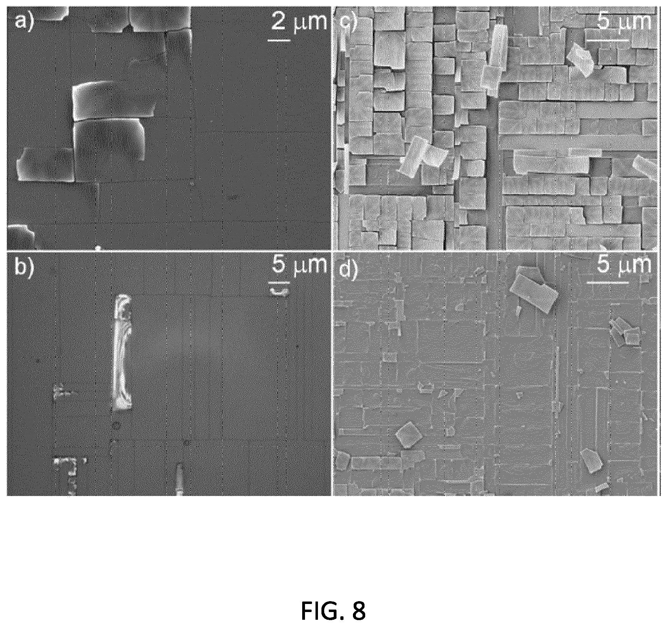

Figure 8 reports scanning electron microscopy (SEM) images a) to d) of portions of the top surface of three different samples in which LAO films were grown under the same process parameters of Example 2 (F=2.0 J/cm²), up to different final thickness of the LAO film. Image a) refers to a region of the surface of a sample with 60 nm thick LAO film. Both vertical cracks and partially free-standing membranes are visible. Image b) is an image of a region of a sample with 100 nm thick LAO film, showing both vertical cracks and partially detached membranes. Image c) is an image of a region of the surface of a sample with 67 nm thick LAO film, the region being covered by free-standing membranes. Image d) is the image of another region of the surface of the same sample illustrated in image c), showing the "naked" STO substrate layer after removal of the free-standing membranes that were present on top of the substrate layer.

Most of the heterostructure membranes of the Examples consistent with the present disclosure exhibited a finite, similar curvature. The radius of curvature of the LAO/STO membranes typically ranged between 5 and 8 µm. Some membranes kept from cracking along a surface side up to a length exceeding 10 µm.

In a few instances, some membranes exhibited in one direction a length up to several tens of microns, which was much larger than that of the majority of other membranes. In these instances the length largely exceeded the radius of curvature, so that the membranes rolled-up in helices.

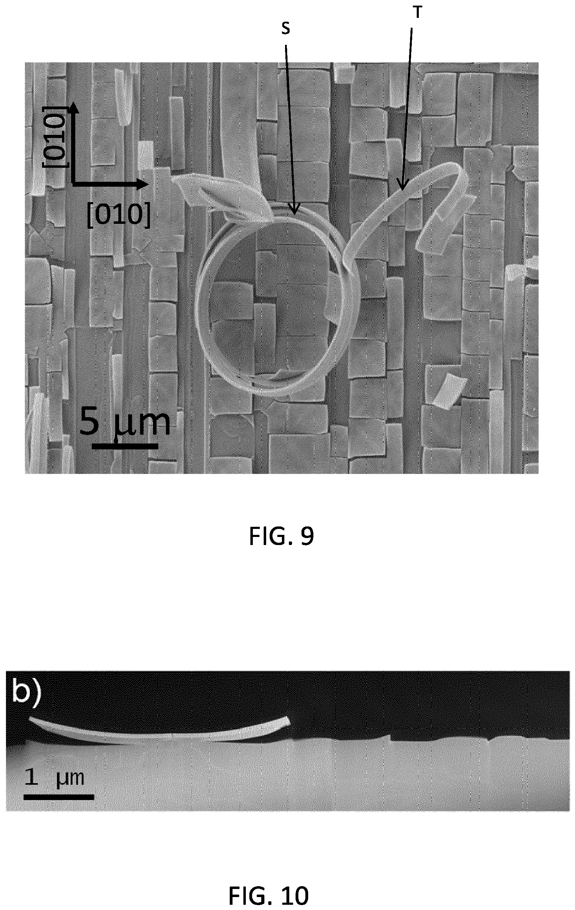

Figure 9 is a SEM image of another region, different from that shown in Fig. 8 a), of the surface of the sample with 60 nm thick LAO film. The SEM image shows that the surface is covered by a mosaic of free-standing, regularly shaped, membranes having an in-plane dimension having surface sides of 2-3 µm and aligned to the in-plane [100] and [010] directions of the substrate. The image shows a twice rolled-up membrane S having a curvature radius of about 5 µm and a tape T.

Inventors observed that, at the end of the growth process, although most of the membranes were fully detached from the underlying portion of the STO substrate, few of them were partially connected to the underlying STO crystal. In an example, in an area 1000 µm² of LAO film on the substrate, the number of membranes formed by the process ranged from about 100 to 300.

Some membranes remain attached to the substrate along one edge, as shown in the example of Fig. 10, which is a cross-sectional TEM image of a portion of a sample after epitaxial growth and in-situ annealing under the same conditions of previous examples. The partially-detached membrane in the image was constituted by a 80 nm-thick LAO film on a STO layer having an average thickness of 100 nm.

In the LAO/STO samples of the Examples, the horizontal fragmentation was observed to occur along the crystallographic planes (100) and (010), and the vertical fragmentation penetrated into the first layers of the STO substrate so that the horizontal break plane was in the substrate itself.

Some free-standing heterostructure membranes according to the above Examples where transferred on a Si/SiO₂ chip and contacted for transport measurements. The flakes exhibited metallic interfacial conductivity, as measured by contact resistance measurements at room temperature. For example, membranes obtained at fluence of 2.0 J/cm², p(O₂) = 2x10⁻² mbar, T = 730°C, d_{T-S} = 37mm for deposition time of 1 hour showed typical values of electrical resistance comprised between 150 e 300 KΩ.

Although the invention has been described with respect to a limited number of embodiments, it will be appreciated that many variations and modifications may be made, and are intended to be within the scope of the appended claims.

## Claims

1. A process of fabricating free-standing LaAlO₃/SrTiO₃ (LAO/STO) heterostructure membranes by pulsed laser deposition, the process comprising:
- placing a STO monocrystalline substrate (15) having a substrate surface (15a) in a processing chamber (19) under vacuum and containing oxygen gas at an oxygen partial pressure, and
- epitaxially growing a LAO film on the substrate surface by pulsed laser ablation of a LAO target (13) by a pulsed laser beam (11), while the STO substrate (15) is at a substrate temperature of 660°C to 800°C, the target (13) being placed in the processing chamber (19) to face the substrate surface (15a),
wherein during growth of the LAO film the pulsed laser beam (11) has a laser pulse fluence on the LAO target (13) of 1.5 J/cm² to 3.0 J/cm² and the oxygen partial pressure inside the processing chamber (19) is of 0.5x10⁻³ to 5.0x10⁻² mbar.

2. The process of one or more of the preceding claims, wherein epitaxially growing the LAO film is up to a final thickness of the LAO film of 25 nm to 500 nm.

3. The process of claim 1 or 2, wherein the laser pulse fluence is of 1.8 to 2.5 J/cm².

4. The process of any one of claims 1 to 3, wherein epitaxially growing the LAO film is up to a final thickness equal to or larger than a detachment thickness value (t_{det}) of from 25 nm to 60 nm.

5. The process of any one of claims 2 to 4, further comprising stopping epitaxial growth upon reaching the final thickness of the LAO film and removing the LAO/STO heterostructure from the processing chamber (19) to expose it in an ambient atmosphere.

6. The process of one or more of the preceding claims, wherein the substrate temperature is of 700°C to 750°C.

7. The process of one or more of the preceding claims, wherein the oxygen partial pressure inside the processing chamber (19) is of 1.0x10⁻² to 5.0x10⁻² mbar.

8. The process of one or more of the preceding claims, wherein the STO substrate is placed at a substrate-target distance, d_{T-S}, from the LAO target of 30 mm to 45 mm.

9. The process of one or more of the preceding claims, wherein epitaxially growing LAO films comprises irradiating a laser spot area of the LAO target (13) with the pulsed laser beam to generate a plasma plume of ablated target material and depositing such material on the substrate surface (15a), and wherein the laser spot area is of 0.5 mm² to 3.0 mm².

10. The process of one or more of the preceding claims, comprising, after epitaxial growth of the LAO film, annealing the STO substrate at a temperature from 400°C to 500°C in an oxygen pressure between 50 mbar and 1 bar.

11. A free-standing LAO/STO heterostructure membrane (60) comprising:
- a SrTiO₃ single-crystal layer (62), and
- an epitaxial LaAlO₃ film (61) on the SrTiO₃ layer (62) so as to form an interface (65) between the LaAlO₃ film (61) and the SrTiO₃ layer (62), the LaAlO₃ film having a thickness of from 25 to 500 nm, the LaAlO₃ film having an upper surface (63),
wherein the heterostructure membrane (60) has opposing surfaces (61, 64), a membrane upper surface (63) corresponding to the upper surface of the LaAlO₃ film (61) and a membrane lower surface (64) corresponding to a lower surface of the SrTiO₃ layer (62).

12. The free-standing LAO/STO heterostructure membrane of claim 11, wherein the heterostructure membrane (60) has a thickness of from 50 nm to 1000 nm.

13. The free-standing LAO/STO heterostructure membrane (60) of claim 11 or 12, wherein the membrane upper surface (63) and the membrane lower surface (64) are curved surfaces, the membrane upper surface (63) having a concave shape and the membrane lower surface (64) having a convex shape with respect to a center of curvature (P).

14. The free-standing LAO/STO heterostructure membrane of claim 13, wherein the membrane curved opposing surfaces (63, 64) have a radius of curvature (R_{curv}) of from 5 µm a 20 µm.

15. The free-standing LAO/STO heterostructure membrane of one or more claims 11-14, wherein the membrane upper surface (63) has a surface area of 0.2 µm² to 100 µm².
